# EUROPÄISCHE PATENTSCHRIFT

(11) **EP 4 340 539 B1**
(45) Veröffentlichungstag und Bekanntmachung des Hinweises auf die Patenterteilung: **02.12.2026**
(21) Anmeldenummer: 23197048.4
(22) Anmeldetag: 13.09.2023
(51) Int. Cl.: H05B 3/06, F24H 3/04, F24H 9/1863, H05B 3/50

(54) **STEUERVORRICHTUNG UND ELEKTRISCHE HEIZVORRICHTUNG UMFASSEND EINE SOLCHE**
CONTROL DEVICE AND ELECTRIC HEATING DEVICE COMPRISING SAME
DISPOSITIF DE COMMANDE ET DISPOSITIF DE CHAUFFAGE ÉLECTRIQUE COMPRENANT UN TEL DISPOSITIF DE COMMANDE

(30) Priorität: 15.09.2022 DE 102022123572
(43) Veröffentlichungstag der Anmeldung: 20.03.2024
(73) Patentinhaber: Eberspächer catem GmbH & Co. KG, 76863 Herxheim (DE)
(72) Erfinder: KRÄCK, Simon Georg, 76133 Karlsruhe (DE); KRÖNER, Timo, 76761 Rülzheim (DE)
(74) Vertreter: Grünecker Patent- und Rechtsanwälte PartG mbB

(56) Entgegenhaltungen:
- CN-A- 102 740 646
- US-A1- 2019 069 438
- US-A1- 2021 394 585
- US-A1- 2022 007 465

## Beschreibung

Die vorliegende Erfindung betrifft eine Steuervorrichtung, insbesondere für eine elektrische Heizvorrichtung mit einem PTC-Element als Zusatzheizer in einem Kraftfahrzeug.

Steuervorrichtungen insbesondere für elektrische Heizvorrichtungen mit einem keramischen PTC-Element zur Beheizung von Kraftfahrzeugen sind im Stand der Technik hinreichend beschrieben, so beispielsweise in EP 1 872 986 A1 oder EP 2 337 425 A1. Eine Steuervorrichtung in einer solchen elektrischen Heizvorrichtung hat üblicherweise ein Steuergehäuse, welches die Steuerkomponenten umgibt und mit Steckanschlüssen zur Verbindung von Steuersignalen und/ oder den zu steuernden Leistungsstrom versehen ist. Die zuvor beschriebenen Beispiele wie auch die elektrische Heizvorrichtung aus EP 3 334 242 A1 verwirklichen ein Konzept, bei dem die Steuervorrichtung integral mit dem Leistungsteil vorgesehen ist. Die Steuervorrichtung hat zumindest einen Leistungsschalter, der beim Betrieb Verlustleistung abgibt. Diese wird üblicherweise dem zu erwärmenden Medium zugeführt. Dementsprechend ist der Leistungsschalter nicht nur mit einem Kühlkörper versehen, der die Verlustleistung abführt und dementsprechend einer Überhitzung des Leistungsschalters entgegenwirkt. Der Kühlkörper ist vielmehr thermisch mit dem zu erwärmenden Fluid gekoppelt. Der Kühlkörper kann dazu in einer Heizkammer vorgesehen sein, die von dem Aufnahmeraum des Steuergehäuses durch eine Trennwand getrennt ist, in welcher der an dem Leistungsschalter anliegende Teil des Kühlkörpers aufgenommen ist. Üblicherweise wird dabei zwischen der Aufnahmekammer des Steuergehäuses und der Heizkammer eine Trennwand vorgesehen, die sowohl die Heizkammer wie auch die Aufnahmekammer des Steuergehäuses begrenzt. Diese Trennwand kann selbst den Kühlkörper ausbilden oder aber von einem gesonderten Kühlkörper durchragt sein. Der Kühlkörper bildet eine Kühlfläche aus, gegen die der Leistungsschalter wärmeleitend anliegt. Das Steuergehäuse kann dabei auch Kontaktzonen von PTC-Heizeinrichtungen in sich aufnehmen, die üblicherweise in die Heizkammer hineinragen und zumindest ein PTC-Element umfassen. So wird das Innere des Steuergehäuses im Stand der Technik auch als Anschlusskammer bezeichnet, da die Kontaktzonen in dieser Kammer elektrisch angeschlossen sind.

Die zuvor erwähnten Merkmale gelten auch für die Verwirklichung der erfindungsgemäßen Steuervorrichtung in einer elektrischen Heizvorrichtung mit einem keramischen PTC-Element als Zuheizer.

Steuervorrichtungen in der Kraftfahrzeugtechnik unterliegen den dort herrschenden Bedingungen. Die Steuerkomponenten innerhalb der Steuervorrichtung werden erheblichen Vibrationen ausgesetzt. Es versteht sich, dass das Steuergehäuse möglichst dicht sein muss, sodass weder Staub noch Feuchtigkeit in das Steuergehäuse eindringen kann. Die verbauten Komponenten müssen aber nicht nur vibrationsfest vorgesehen sein. Es wird eine Konstruktion angestrebt, die mit möglichst wenig Bauteilen die gewünschte Funktionalität bereitstellt. Dabei sollten die Bauteile sich leicht herstellen lassen, skalierbar sein und im Rahmen der Herstellung unempfindlich zu handhaben sein. Die Bauteile müssen über die Lebensdauer des Kraftfahrzeuges und trotz der oben genannten Bedingungen funktionsfähig bleiben.

Die vorliegende Erfindung ist insbesondere mit dem Problem befasst, den Leistungsschalter wärmeleitend unter Vorspannung gegen einen Kühlkörper anzulegen. Hierzu hat es bereits im Stand der Technik nicht an Vorschlägen gefehlt.

So offenbart beispielsweise EP 1 395 098 A1 eine Steuervorrichtung einer elektrischen Heizvorrichtung mit einem PTC-Element, bei welcher ein Kühlkörper unmittelbar wärmeleitend gegen einen auf einer Leiterplatte montierten Leistungsschalter anliegt und auf der dem Leistungsschalter gegenüberliegenden Seite von der Leiterplatte abragt. Der Kühlkörper und der Leistungsschalter werden von einer C-förmigen Federklaue umgriffen, die die beiden Bauteile unter Vorspannung gegeneinander angelegt hält.

Die US 2022/007465 A1 offenbart eine Steuervorrichtung einer elektrischen Heizvorrichtung mit einem PTC-Element, bei welcher ein Kühlkörper unter Zwischenlage mit einem auf einer Leiterplatte montierten Leistungsschalter wärmeleitend gekoppelt ist. Dieser Leistungsschalter wird über einen Niederhalter unter Kompression einer Feder gegen den Kühlkörper gedrängt.

Die US 2019/069438 A1 offenbart eine Steuervorrichtung mit einer Leiterplatte und Leistungstransistoren, die mit ihrer Unterseite an einem Gehäuse mit Kühlrippen und anliegen.

Die CN 102 740 646 A offenbart einen Kühlkörper an dem ein Leistungsschalter unter Zwischenlage einer Isolierschicht wärmeleitend anliegt und der mit einer Leiterplatte kontaktiert ist, die von einer Schraube durchsetzt ist, die auch den Kühlkörper durchsetzt.

Bei dem aus US 5,812,375 bekannten Konstruktionsprinzip wird der Leistungsschalter unter Zwischenlage einer elektrisch isolieren Folie gegen die Oberfläche einer Wärmesenke angelegt, die in eine Aufnahmeöffnung einer Leiterplatte eingreift, mit deren Leiterbahnen der Leistungsschalter elektrisch verbunden ist. Auf der der Wärmesenke gegenüberliegenden Seite liegt ein in Querschnitt U-förmiges elastomeres Bauteil gegen den Leistungsschalter ab, welches sich an einem Gehäusedeckel des Steuergehäuses abstützt. Dafür hat der Gehäusedeckel einen Vorsprung, der von dem im Querschnitt U-förmigen Vorspannmittel umgriffen ist.

DE 100 34 572 A1 offenbart eine Steuervorrichtung für einen Zusatzhalter eines Kraftfahrzeugs, bei welcher von einem Gehäusedeckel ein zumindest partiell elastischer Pressvorsprung abragt, der gegenüberliegend zu einem Kühlkörper vorgesehen ist, der wärmeleitend mit der Heizkammer gekoppelt ist. Zwischen dem Pressvorsprung und dem Kühlkörper ist ein Leistungsschalter angeordnet, der unter Zwischenlage einer gegebenenfalls elastischen, wärmeleitenden jedoch elektrisch isolierenden Folie gegen den Kühlkörper anliegt.

Zur vibrationsfreien Abstützung der Leiterplatte an einem Gehäuseboden eines Steuergehäuses, schlägt DE 196 00 619 A1 ein auf den Leistungsschalter wirkendes Vorspannmittel in Form eines Elastomerstreifens vor, welcher den Leistungsschalter und dazwischen Lage der Leiterplatte gegen einen äußeren Rand des Steuergehäuses andrückt.

Die aus dem Stand der Technik bekannten Lösungen lassen noch Wünsche offen. Die aus DE 196 00 619 A1 vorbekannte Lösung ist nicht immer in der Praxis anwendbar, da diese Lösung einen erhabenen Randbereich bedingt, gegen den die Leiterplatte anliegt. Der Randbereich der Steuervorrichtung befindet sich bei einer elektrischen Heizvorrichtung mit baulicher Einheit aus Steuerteil und Leistungsteil nicht immer unterhalb des Randbereichs des Steuergehäuses.

Des Weiteren muss mitunter eine gewisse Höhe zwischen dem Leistungsschalter und einem Gehäusedeckel überbrückt werden, sodass der aus DE 196 00 619 A1 bekannte Elastomerstreifen für die Anlage des Leistungsschalters unter Vorspannung gegen einen Kühlkörper ungeeignet ist.

Im Hinblick darauf schlägt die auf die vorliegende Anmelderin zurückgehende EP 2 466 989 A1 ein Tragwerk vor, welches zwischen dem Gehäusedeckel und einer Leiterplatte vorgesehen ist und einen elastischen Niederhalter aus einem kompressiblen Kunststoff abstützt, der die Leiterplatte durchragt und gegen einen Leistungsschalter anliegt, um diesen unter Vorspannung gegen die Kühlfläche einer Wärmesenke anzulegen, die wärmeleitend mit der Heizkammer verbunden ist.

Die vorliegende Erfindung will eine Steuervorrichtung angeben, die eine gute Wärmeübertragung zwischen dem Leistungsschalter und der Kühlfläche erlaubt und sich leicht und kostengünstig herstellen lässt.

Zur Lösung des obigen Problems wird mit der vorliegenden Erfindung eine Steuervorrichtung mit dem Merkmal von Anspruch 1 vorgeschlagen.

Nach der vorliegenden Erfindung ist der Leistungsschalter zusammen mit dem Niederhalter in einer vormontierten Baugruppe verwirklicht, die mit dem Kühlkörper verbunden ist. Dabei kann der Niederhalter als solches Aufnahmen für den oder die mehreren Leistungsschalter ausbilden. Die Leistungsschalter sind dabei zumindest in einer Richtung quer zu der Leiterplatte in vorbestimmter Anordnung gehalten. Der Niederhalter ist bevorzugt aus einem Kunststoffmaterial gebildet. Der Niederhalter ist bevorzugt aus elastischen Material, insbesondere einem elastischen oder weichelastischen Kunststoff gebildet und/oder stützt eine Federeinrichtung, die beispielsweise durch ein aus diesem elastischen oder weichelastischen Kunststoffmaterial gebildetes Vorspannelement gebildet sein kann, ab. Bevorzugt erzeugt der Niederhalter eine den Leistungsschalter gegen eine Kühlfläche des Kühlkörpers wirkende Vorspannkraft oder stützt eine solche elastische Vorspannkraft ab. Der Niederhalter ist bevorzugt unmittelbar mit dem Steuergehäuse verbunden, bevorzugt mit diesem verschraubt.

Durch die Baugruppe kann der oder die mehreren Leistungsschalter einheitlich gehandhabt und in der Steuervorrichtung montiert werden. Damit lässt sich eine kostengünstige Fertigung verwirklichen. Dies gilt insbesondere dann, wenn in der Steuervorrichtung mehrere Leistungsschalter verbaut sind die in der Baugruppe aufgenommen sind.

Im Hinblick auf eine möglichst gute Wärmeauskopplung der von den Leistungsschaltern erzeugten Wärme hat die Steuervorrichtung bevorzugt zumindest eine Federeinrichtung. Üblicherweise ist eine einzige Federeinrichtung einem entsprechenden Leistungsschalter zugeordnet, so dass der Leistungsschalter durch diese Federeinrichtung vorgespannt gehalten wird. Die Vorspannung erfolgt derart, dass der Leistungsschalter unter Vorspannung gegen die Kühlfläche angelegt ist. Bei dieser bevorzugten Weiterbildung ist die Federeinrichtung in der Baugruppe aufgenommen. So kann durch Handhaben und Montieren der Baugruppe der Leistungsschalter unter Vorspannung gegen die Kühlfläche angelegt werden.

Die Federeinrichtung ist bevorzugt über zumindest eine quer zu der Kraftwirkungsrichtung ihrer Federkraft wirkende Formschlussverbindung an dem Niederhalter gehalten. Dazu kann der Niederhalter einen sich im Grunde rechtwinklig zu der Haupterstreckung der Leiterplatte erstreckenden Zapfen aufweisen, der von der Federeinrichtung formschlüssig umgriffen ist. Jede andere Art einer formschlüssigen Verbindung ist indes denkbar. Allerdings hat sich eine Zapfenverbindung als vorteilhaft erwiesen, wenn die Federeinrichtung aus einem Kunststoff gebildet ist, insbesondere aus einem Silikon und als Hohlkörper verwirklicht, so dass der Zapfen in den Hohlkörper eingreifen und diesen formschlüssig halten kann. Eine Federeinrichtung aus einem Silikon bietet sich auch wegen der guten Wärmebeständigkeit des Kunststoffs an. Des Weiteren bewirkt eine Silikonfeder eine gute elastische und elektrisch isolierende Abstützung des Leistungsschalters.

Gemäß einer bevorzugten Weiterbildung der vorliegenden Erfindung ist der Leistungsschalter unter Veränderung einer durch die Federeinrichtung bewirkten Vorspannung in der Baugruppe beweglich gehalten. So hat die Baugruppe eine Auflage, die verhindert, dass der Leistungsschalter aufgrund der wirkenden Federkraft aus der Baugruppe herausgedrückt wird. Andererseits ist der Leistungsschalter unter Erhöhung der Federkraft der Federeinrichtung von der Auflage weg bewegbar. Dabei ist die Gestaltung üblicherweise so gewählt, dass der Leistungsschalter auch mit zunehmender Kompression der Feder flächig an der Kühlfläche anliegt. So bleibt der Leistungsschalter innerhalb der Baugruppe, kann aber in gewissen Grenzen durch Bewegung innerhalb der Baugruppe einer vorspannenden Anlage gegen die Kühlfläche ausweichen. So kann die Vorspannkraft ungehindert auf den Leistungsschalter wirken.

Gemäß einer bevorzugten Weiterbildung der vorliegenden Erfindung hat die Baugruppe einen Positionierrahmen. Dieser bildet zumindest eine Aufnahme für einen Leistungsschalter aus. In der Aufnahme ist der Leistungsschalter üblicherweise zumindest in einer Richtung quer zu der Ebene der Leiterplatte formschlüssig gehalten. Aus den zuvor genannten Gründen ist der Leistungsschalter regelmäßig quer zu dieser Erstreckungsrichtung der Leiterplatte innerhalb des Positionierrahmens beweglich.

Im Hinblick auf eine kostengünstige Fertigung sind der Positionierrahmen und der Niederhalter üblicherweise aus Kunststoff ausgebildet. Beide Bauteile sind bevorzugt unter Einschluss des zumindest einen Leistungsschalters und - soweit vorhanden - der Federeinrichtung miteinander verclipst. Zur Montage wird der Leistungsschalter in dem Positionierrahmen aufgenommen. Danach wird der so mit dem oder den Leistungsschaltern bestückte Positionierrahmen durch Verclipsen mit dem Niederhalter verbunden. Dieser kann zuvor mit der dem Leistungsschalter zugeordneten Federeinrichtung versehen sein. Die Verbindung zwischen dem Positionierrahmen und dem Niederhalter kann eine im Wesentlichen starre Verbindung zwischen den beiden Bauteilen ergeben. Ebenso gut kann die durch Verclipsen hergestellte Rastverbindung so sein, dass auch der Positionierrahmen in einer Richtung rechtwinklig zu der Kühlfläche beweglich ist, wodurch das flächige Anlegen des Leistungsschalters gegen die Kühlfläche begünstigt werden kann.

Der Positionierrahmen hat üblicherweise eine die Kühlfläche umgebende Öffnung. Diese ist so dimensioniert, dass die Kühlfläche üblicherweise in die Öffnung eingreifen und mit dem Leistungsschalter wärmeleitend kontaktiert werden kann. Die Öffnung ist durch eine Auflage für den Leistungsschalter begrenzt. Auf diese Auflage wird der Leistungsschalter im Rahmen der Montage abgelegt. Diese Auflage lagert den Leistungsschalter wider, wenn nach dem Fügen des Positionierrahmens und des Niederhalters die Federeinrichtung gegen den Leistungsschalter wirkt. So stellt die Auflage im Rahmen der Montage eine Gegenfläche dar, gegen welche der Leistungsschalter aufgrund der Federeinrichtung angedrückt wird.

Gemäß einer weiteren bevorzugten Ausgestaltung der vorliegenden Erfindung weist der Positionierrahmen ein zumindest von einem Kontaktstift des Leistungsschalters durchragtes Fenster auf. Dieses Fenster ist oberseitig durch den Niederhalter begrenzt. Vor dem Fügen von Niederhalter und Positionierrahmen kann der Leistungsschalter dementsprechend in den Positionierrahmen eingelegt werden, wobei der oder die Kontaktstifte von oben durch die Öffnung des Positionierrahmens in das Fenster eingebracht werden. Dadurch wird das Bestücken des Positionierrahmens mit dem oder den Leistungsschaltern vereinfacht.

Die Steuervorrichtung kann kühlkörperseitige Formschlusssegmente aufweisen, die zur Positionierung der Baugruppe quer zu der Ebene der Leiterplatte mit Formschlussgegensegmenten der Baugruppe zusammenwirken. Diese Formschlussgegensegmente sind bevorzugt an dem Niederhalter verwirklicht. Das Zusammenwirken der Formschlusssegmente mit den Formschlussgegensegmenten führt zu einer angemessenen Vorpositionierung der Baugruppe relativ zu dem Kühlkörper im Rahmen der Montage, so dass der Leistungsschalter sicher gegen die Kühlfläche angelegt wird.

Ein Leistungsschalter nach der vorliegenden Erfindung kann beispielsweise durch einen MOSFET oder ein IGBT gebildet sein. Die Anlage gegen die Kühlfläche kann dabei unter Zwischenlage einer elektrisch isolierenden Folie, beispielsweise einer Polyimid-Folie erfolgen, um die Kühlfläche elektrisch von dem Leistungsschalter zu entkoppeln, gleichwohl aber eine gute Wärmeleitung von dem Leistungsschalter auf die Kühlfläche zu ermöglichen. Alternativ kann auch eine Keramikplatte zwischen der Kühlfläche und dem Leistungsschalter vorgesehen sein.

Im Hinblick auf eine leichte Aufbringung der Vorspannkraft für das vorgespannte Anlegen des Leistungsschalters gegen die Kühlfläche wird die Baugruppe üblicherweise in einer Richtung rechtwinklig zu der Erstreckung der Leiterplatte mit dem Anschlussgehäuse verbunden. Dies erfolgt bevorzugt durch Schrauben, die innerhalb der Formschlusssegmente gehalten sein können. Durch Anziehen der Schrauben wird auch die Vorspannkraft der Federeinrichtung bewirkt oder erhöht, jedenfalls aber der bzw. die Leistungsschalter unter Vorspannung gegen den Kühlkörper angelegt.

Gemäß deren nebengeordneten Aspekt schlägt die vorliegende Erfindung eine elektrische Heizvorrichtung mit den Merkmalen von Anspruch 10 vor. Diese elektrische Heizvorrichtung hat in der bereits aus EP 2 466 989 A1 bekannten Weise eine Trennwand zwischen Steuergehäuse und einem Heizergehäuse. Diese Trennwand bildet üblicherweise sowohl einen Abschluss einer durch das Heizergehäuse gebildeten Heizkammer wie auch einen Abschluss des Steuergehäuses. Von der Trennwand ragt zumindest eine PTC-Heizeinrichtung als Heizrippe in das Heizergehäuse hinein. Die PTC-Heizeinrichtung kann steckkontaktiert in der Trennwand aufgenommen oder in anderer Weise relativ dazu positioniert und festgelegt sein. Die PTC-Heizeinrichtung hat zumindest ein PTC-Element und zur Bestromung desselben mit unterschiedlicher Polarität mit diesem elektrisch leitend verbundene Leiterbahnen. Die Leiterbahnen sind in dem Steuergehäuse elektrisch angeschlossen. Sie ragen dazu in das Steuergehäuse hinein und können mit der Leiterplatte, die auch den Leistungsschalter trägt, oder einen anderen Leiterplatte, die zur Gruppierung von Heizkreisen umfassend mehrere PTC-Heizeinrichtungen vorgesehen ist, steckkontaktiert sein. In der Heizkammer liegt eine Wärmesenke frei, die wärmeleitend mit einer in der Anschlusskammer vorgesehenen Kühlfläche verbunden ist. Gegen diese Kühlfläche liegt der Leistungsschalter an, sodass die von dem Leistungsschalter abgegebene Verlustleistung auch zum Erwärmen des in der Heizvorrichtung zu erwärmenden Fluids genutzt werden kann. Dieses Fluid kann ein flüssiges Fluid oder ein gasförmiges Fluid insbesondere Luft sein.

Diese zuvor erwähnte elektrische Heizvorrichtung hat eine Steuervorrichtung nach einem der vorherigen Ansprüche.

Weitere Einzelheiten und Vorteile der vorliegenden Erfindung ergeben sich aus der nachfolgenden Beschreibung in Verbindung mit der Zeichnung. In dieser zeigt:
- Fig. 1: eine perspektivische Explosionszeichnung eines Ausführungsbeispiels einer elektrischen Heizvorrichtung;
- Fig. 2: eine Längsschnittansicht einer PTC-Heizeinrichtung der Heizvorrichtung nach Figur 1;
- Fig. 3: eine perspektivische Seitenansicht einer Baugruppe über der Leiterplatte und dem Kühlkörper;
- Fig. 4: eine Längsschnittansicht einer Baugruppe nach der Montage;
- Fig. 5: eine Querschnittansicht der Baugruppe nach Figur 3;
- Fig. 6: eine perspektivische Seitenansicht eines Ausrichtelements vor der Montage;
- Fig. 7: eine perspektivische Seitenansicht eines Ausrichtelements nach der Montage;
- Fig. 8: ein vergrößertes Detail von Figur 5;
- Fig. 9: eine Draufsicht zu der Darstellung nach Figur 8.

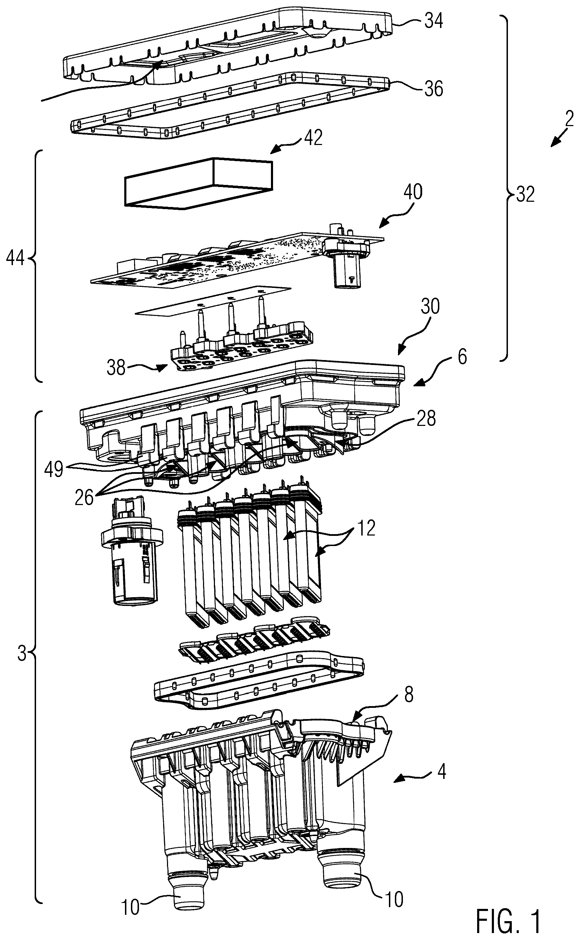

Die Figur 1 zeigt ein Ausführungsbeispiel einer elektrischen Heizvorrichtung 2 mit einem mehrteiligen Heizergehäuse 3, das ein aus Kunststoff gebildetes Gehäuseunterteil 4 und ein mittels Druckguss einteilig aus Metall ausgebildetes Gehäuseoberteil 6 umfasst.

Das Gehäuseunterteil 4 ist wannenförmig ausgebildet, umschließt eine Heizkammer 8 und bildet Öffnungen zu Ein- und Auslassstutzen 10 aus, die mit der Heizkammer 8 kommunizieren. Diese Ein- und Auslassstutzen 10 sind einteilig mit dem Gehäuseunterteil 4 mittels Spritzgießen ausgeformt. Zwischen dem Gehäuseoberteil 6 und dem Gehäuseunterteil 4 sind mehrere PTC-Heizeinrichtungen 12 dargestellt.

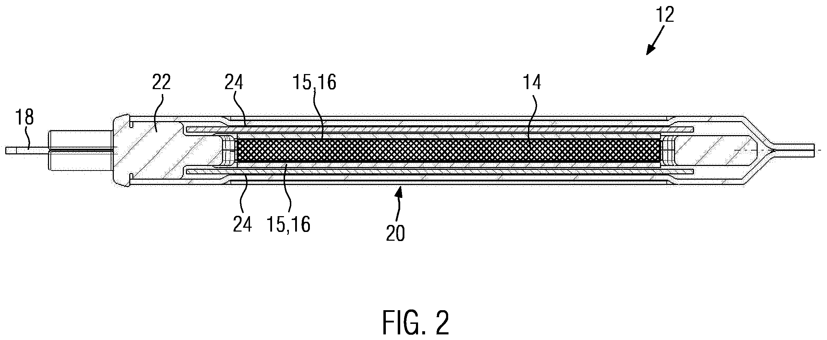

Wie Figur 2 verdeutlicht haben diese PTC-Heizeinrichtungen 12 jeweils zumindest ein PTC-Element 14, an dem Leiterelemente 15 in Form von Kontaktblechen 16 anliegen, die Kontaktzungen 18 ausbilden, welche ein metallisches Gehäuse 20 überragen. Das PTC-Element 14 ist in einem Rahmen 22 und zwischen den Kontaktblechen 16 aufgenommen. Zwischen dem metallischen Gehäuse 20 und den Kontaktblechen 16 ist jeweils eine Isolierlage 24 vorgesehen.

Die PTC-Heizeinrichtungen 12 sind steckkontaktiert in dazu vorgesehenen Aufnahmen 26 einer Trennwand 28 des Gehäuseoberteils 6 gehalten. Details dieser Ausgestaltung sind in der auf die Anmelderin zurückgehenden EP 3 334 242 A1 beschrieben.

Auf der den PTC-Heizeinrichtungen 12 gegenüberliegenden Seite der Trennwand 28 ist eine Anschlusskammer 30 ausgebildet, die von einem Steuergehäuse 32 umgeben wird, dass einen Steuergehäusedeckel 34 aufweist, der abgedichtet über eine Dichtung 36 mit dem Gehäuseoberteil 6 verbunden ist. In der Anschlusskammer 30 befindet sich eine erste Leiterplatte 38, die die Kontaktzungen 18 in sich aufnimmt und die einzelnen PTC-Heizeinrichtungen 12 zu Heizkreisen gruppiert.

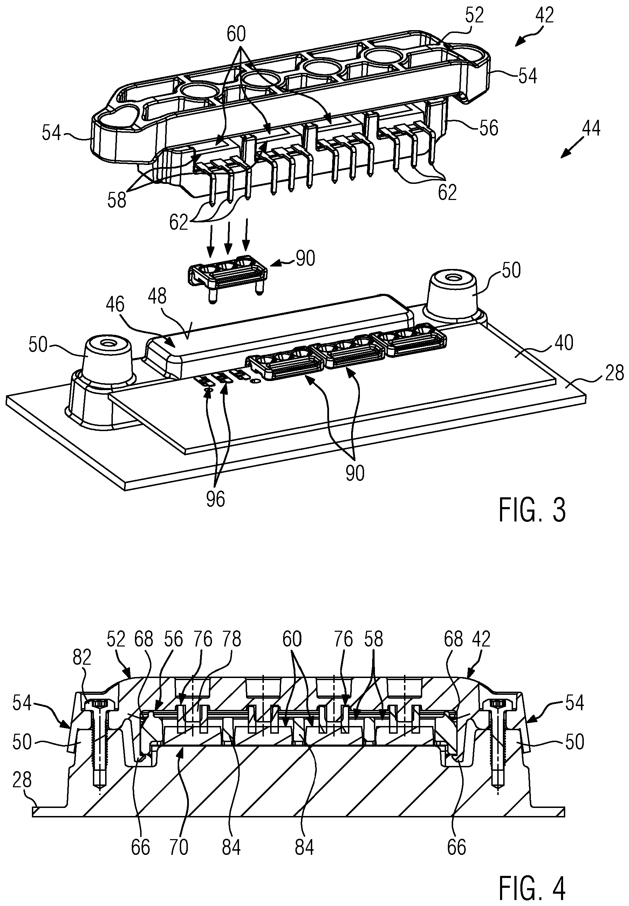

In dem Steuergehäuse 32 ist eine mit Bezugszeichen 40 gekennzeichnete zweite Leiterplatte vorgesehen, die mit im Detail nicht dargestellten elektronischen Bauteilen bestückt ist. Bezugszeichen 42 kennzeichnet eine in den weiteren Figuren 3 ff im Einzelnen näher dargestellte Baugruppe, die Teil der in Figur 1 mit Bezugszeichen 44 gekennzeichneten Steuervorrichtung ist.

Die Fig. 3 zeigt neben der Baugruppe 42 schematisch die Trennwand 28, von der ein Kühlkörper 46 in Richtung auf die Anschlusskammer 30 vorspringt. Dieser Kühlkörper 46 bildet eine ebene Kühlfläche 48 aus. Die Kühlkörper 46 sind in die Heizkammer 8 verlängert und bilden dort Wärmesenken 49 aus. In Verlängerung zu der Kühlfläche 48 und benachbart dazu werden ebenfalls durch das Gehäuseoberteil 6 kühlkörperseitige Formschlusssegmente 50 ausgebildet, die als leicht konische Vorsprünge ebenfalls von der vorliegend schematisch plan dargestellten Trennwand 28 abragen.

Die Baugruppe 42 umfasst einen Niederhalter 52, der als längliches Kunststoffbauteil ausgebildet ist und an seinen jeweiligen Enden Formschlussgegensegmente 54 ausbildet, die formschlüssig mit den Formschlusssegmenten 50 zusammenwirken können, um den Niederhalter 52 relativ zu dem Gehäuseoberteil 6 und damit dem Steuergehäuse 32 zu positionieren.

Mit Bezugszeichen 56 ist ein Positionierrahmen gekennzeichnet, der mehrere Aufnahmen 58 für Leistungsschalter 60 ausformt. Jeder Leistungsschalter 60 hat drei mit Bezugszeichen 62 gekennzeichnete Kontaktstifte, die in etwa mittig um 90 Grad umbogen sind und einen kontaktseitigen Abschnitt 64 aufweisen, der sich im Wesentlichen rechtwinklig zu der Haupterstreckung der Leiterplatte 40 erstreckt.

Wie Fig. 4 vermittelt, hat der Niederhalter 52 seitliche Rastklinken 66, die den Positionierrahmen 56 unterseitig umgreifen. Als unterseitig wird die der Leiterplatte 40 zugewandte Seite der Baugruppe 42 bezeichnet. Der Positionierrahmen 56 hat korrespondierend zu diesen Rastklinken 66 an seiner Oberseite Rampenflächen 68, an denen im Rahmen der Montage die Rastklinken 66 abgleiten, wenn der Niederhalter 52 mit dem Positionierrahmen 56 verclipst wird.

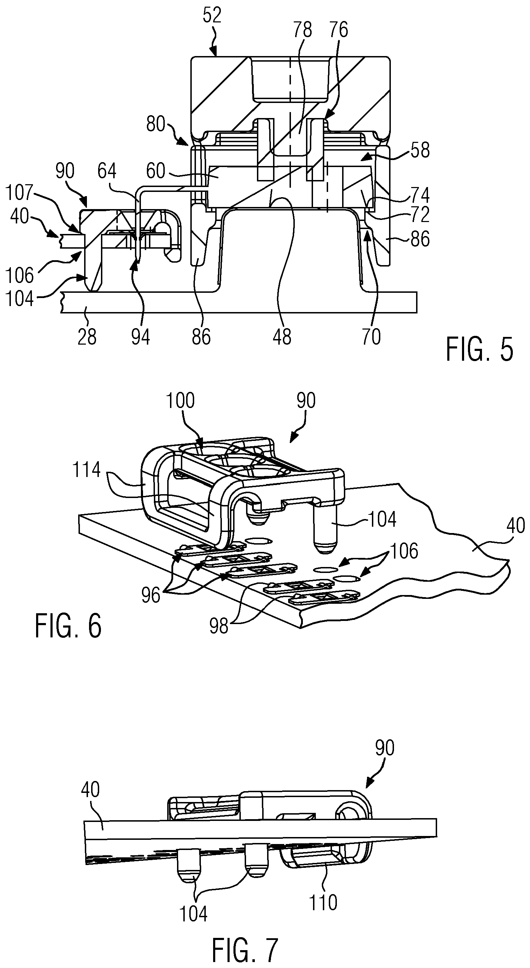

Wie die Fig. 4 und 5 erkennen lassen, sind die Aufnahmen 58 an die Abmessungen der Leistungsschalter 60 im Wesentlichen angepasst. Unterseitig bildet der Positionierrahmen 56 eine Öffnung 70 aus, in der die Leistungsschalter 60 jeweils freiliegen. Die Öffnung 70 wird begrenzt von einem in Richtung auf die Öffnung 70 vorspringenden Steg 72, der eine Auflage 74 für den Leistungsschalter 60 ausbildet. Die Fig. 4 und 5 lassen ferner eine Federeinrichtung in Form einer als Hohlkörper ausgebildeten Silikonfeder 76 erkennen. Die Silikonfeder 76 ist vorliegend als kurzes Schlauchstück ausgebildet und auf einen durch den Niederhalter 52 gebildeten Zapfen 78 aufgesteckt, wodurch sich zwischen der Silikonfeder 76 und dem Niederhalter 52 eine Formschlussverbindung ergibt, durch welche die Silikonfeder 76 rechtwinklig zu ihrer Federkraft relativ zu dem Niederhalter 52 fixiert ist.

Im Rahmen der Montage werden zunächst die einzelnen Komponenten bereitgestellt. Sodann kann die Silikonfeder 76 auf die jeweiligen Zapfen 78 aufgesteckt werden, um den Niederhalter 52 mit den Federeinrichtungen zu versehen. Parallel werden die einzelnen Leistungsschalter 60 in die ihnen zugeordneten Aufnahmen 58 eingebracht. Dafür hat der Positionierrahmen 56 ein mit Bezugszeichen 80 in Fig. 5 gekennzeichnetes Fenster, welches das Absenken des Leistungsschalters 60 in die Aufnahme 58 ohne Beeinträchtigung der Ausrichtung der Kontaktstifte 62 erlaubt. Nach dem Montieren der jeweiligen Leistungsschalter 60 liegen diese auf der Auflage 74 auf. Sodann wird der Niederhalter 52 dem Positionierrahmen 56 angenähert. Dabei gleiten die Rastklinken 66 an den Rampenflächen 68 vorbei. Die Rastklinken 66 werden gespreizt und federn auf der Unterseite des Positionierrahmens 56 zurück, wodurch eine formschlüssige Verbindung zwischen dem Niederhalter 52 und dem Positionierrahmen 56 gebildet ist. Im Rahmen dieser Fügebewegung werden die Silikonfedern 76 zwischen dem Niederhalter 52 und den Leistungsschaltern 60 aufgenommen, gegebenenfalls geringfügig vorgespannt. Die so hergestellte Baugruppe 42 wird dann in dem Steuergehäuse 32 montiert. Dazu wird die Baugruppe 42 dem Gehäuseoberteil 6 angenähert. Der Kühlkörper 46 durchsetzt dabei die Öffnung 70 und legt sich gegen die Leistungsschalter 60 wärmeleitend an. Zwischen der Kühlfläche 48 und den Leistungsschaltern 60 ist üblicherweise zuvor eine isolierende Lage, beispielweise in Form einer Polyimid-Folie oder einer Keramiklage eingebracht worden, um einen unmittelbaren elektrischen Kontakt zwischen dem Leistungsschalter 60 und dem Kühlkörper 46 zu vermeiden. Die Fügebewegung mag durch das Zusammenwirken der Formschlusssegmente 50 mit den Formschlussgegensegmenten 54 geführt werden. Hierdurch kann sich eine Vorpositionierung der Baugruppe 42 relativ zu dem Kühlkörper 46 ergeben.

Sodann werden mit Bezugszeichen 82 gekennzeichnete Schrauben in das Gehäuseoberteil 6 eingeschraubt. Diese bewirken eine Festlegung des Niederhalters 52 auf dem Gehäuseoberteil 6 und damit eine Kompression der Silikonfedern 76 und dementsprechend eine Anlage der Leistungsschalter 60 unter Vorspannung. Ersichtlich ist die Öffnung entsprechend dimensioniert, so dass der Kühlkörper 46 problemlos in den Positionierrahmen 56 eintauchen kann. Die einzelnen Aufnahmen 58 in Längsrichtung des Niederhalters 52 begrenzende Querholme 84 des Positionierrahmens 56, die die jeweiligen Aufnahmen 58 voneinander trennen, lassen eine entsprechende Bewegung zu. Diese Querholme 84 sind gegenüber in Fig. 5 eingezeichneten Längsholme 86 höhenmäßig zurückgenommen.

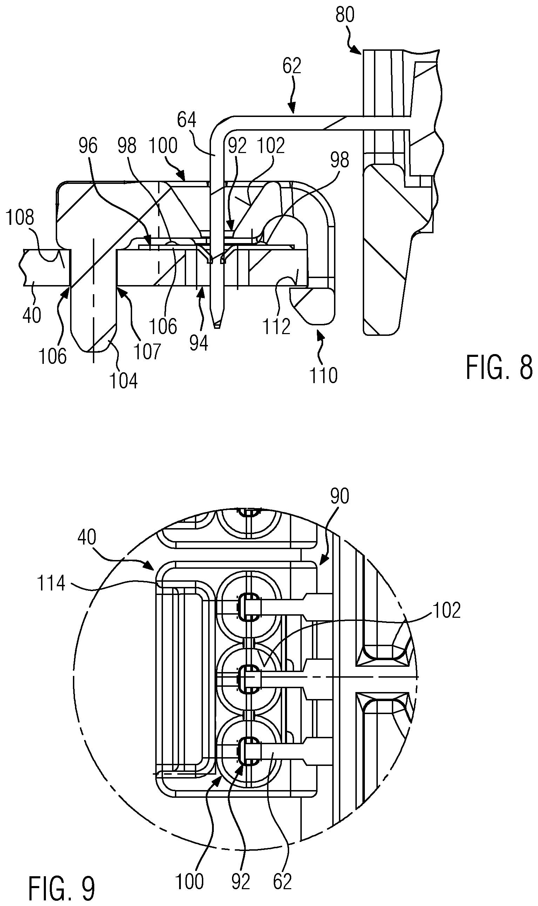

Die Fig. 6 bis 9 verdeutlichen ein in Fig. 5 mit Bezugszeichen 90 gekennzeichnetes Ausrichtelement aus einem Kunststoff. Dieses dient der leichteren Einbringung des kontaktseitigen Abschnitts 46 des Kontaktstifts in die Leiterplatte 40. Das Ausrichtelement 90 hat einen Durchlass 92, der mit einem Steckplatz 94 für den jeweiligen Kontaktstift 62 innerhalb der Leiterplatte 40 fluchtet. Der Steckplatz 94 wird durch ein elektrisch mit zumindest einer Leiterbahn der Leiterplatte 40 kontaktierten Anschlussstück 96 geschaffen, dessen Details in EP 2 236 330 A1 beschrieben und welches in den Fig. 6 und 8 dargestellt ist. Dieses Anschlussstück 96 liegt im Grunde plan auf der Oberseite der Leiterplatte 40 auf. Lediglich nach oben umbogene Radien 98 von Haltestegen, die in Bohrungen der Leiterplatte 40 eingreifen, überragen geringfügig die ansonsten plane Oberfläche der Anschlussstücke 96.

Wie insbesondere die Fig. 8 und 9 erkennen lassen, hat das Ausrichtelement 90 um den Durchlass 92 auf der der Leiterplatte 40 abgewandten Seite eine gegenüber den Abmessungen des Durchlasses 92 deutlich verbreiterte Öffnung 100. Diese Öffnung 100 geht über nach innen geneigte Rampenflächen 102 absatzfrei in den Durchlass 92 über. Das Ausrichtelement 90 ist so auf der Leiterplatte 40 montiert, dass der Durchlass 92 exakt mit dem Steckplatz 94 innerhalb der Leiterplatte 40 fluchtet. Dazu weist das Ausrichtelement 90 Positionierstifte 104 auf, die eine Positionierbohrung 106 innerhalb der Leiterplatte 40 durchsetzen und die Leiterplatte 40 unterseitig überragen. Die Positionierstifte 104 gehen von einem Vorsprung ab, der eine Anlagefläche 108 ausbildet, die ringförmig um den Positionierstift 104 vorgesehen ist. Über die Anlageflächen 108 liegt das Ausrichtelement 90 gegen die Leiterplatte 40 an. Wie den Fig. 6 und 7 zu entnehmen ist, sind zu jedem Ausrichtelement 90 zwei Positionierstifte 104 und entsprechende Positionierbohrungen vorgesehen. Durch dieses Zusammenwirken sind bereits Elemente einer Formschlussverbindung 107 geschaffen, durch welche das Ausrichtelement 90 quer zu der Leiterplatte 40 formschlüssig an der Leiterplatte 40 gehalten und in diesem Sinne befestigt ist.

Wie insbesondere die Fig. 6, 7 und 8 erkennen lassen, hat das Ausrichtelement 90 ferner einen Rastschenkel 110, der eine gegen die Unterseite der Leiterplatte 40 anliegende Verriegelungsfläche 112 ausformt. Auch dieser Rastschenkel 110 verclipst gegen die Leiterplatte 40. Der Rastschenkel 110 ist durch zwei Verbindungsstege 114 angebunden, die mit einem gewissen Querabstand gegen die Stirnfläche der Leiterplatte 40 anliegen. Durch diese Ausgestaltung ist die Leiterplatte randseitig von dem Ausrichtelement 90 umgriffen.

Wie Fig. 5 verdeutlicht, liegen die freien Enden der Positionierstifte 104 gegen die Trennwand 28 an. Dadurch wird das Ausrichtelement 90 lokal im Bereich des Durchlasses 92 abgestützt, wodurch die Leiterplatte 40 beim Einbringen der Kontaktstifte 62 mechanisch entlastet wird.

Wie Fig. 6 erkennen lässt, hat das dort gezeigte Ausrichtelement 90 mehrere Durchlässe 92 mit entsprechenden Öffnungen 100 und Rampenflächen 102. Der Vergleich dieser Darstellung mit Fig. 3 vermittelt, dass zu jedem Leistungsschalter 60 ein einzelnes Ausrichtelement 90 vorgesehen ist. So entspricht die Anzahl der Durchlässe 92 pro Ausrichtelement 90 der Anzahl der Kontaktstifte 62 des Leistungsschalters 60. Die Fig. 3 vermittelt vier in Reihe nebeneinander mit der Leiterplatte 40 verbundene Ausrichtelemente 90.

Im Rahmen der Montage der Baugruppe 42 werden die einzelnen Kontaktstifte 62 mit ihren kontaktseitigen Abschnitten 64 über die jeweiligen Rampenflächen 102 der entsprechenden Ausrichtelemente 90 auf die Steckplätze 94 ausgerichtet. Eine etwaige Fehlstellung wird üblicherweise durch die Elastizität der Kontaktstifte 62 ausgeglichen.

### Bezugszeichenliste

- 2: Heizvorrichtung
- 3: Heizergehäuse
- 4: Gehäuseunterteil
- 6: Gehäuseoberteil
- 8: Heizkammer
- 10: Ein- und Auslassstutzen
- 12: PTC-Heizeinrichtung
- 14: PTC-Element
- 15: Leiterelement
- 16: Kontaktblech
- 18: Kontaktzunge
- 20: Gehäuse
- 22: Rahmen
- 24: Isolierlage
- 26: Aufnahmen
- 28: Trennwand
- 30: Anschlusskammer
- 32: Steuergehäuse
- 34: Steuergehäusedeckel
- 36: Dichtung
- 38: erste Leiterplatte
- 40: zweite Leiterplatte
- 42: Baugruppe
- 44: Steuervorrichtung
- 46: Kühlkörper
- 48: Kühlfläche
- 49: Wärmesenke
- 50: Formschlusssegmente
- 52: Niederhalter
- 54: Formschlussgegensegmente
- 56: Positionierrahmen
- 58: Aufnahme
- 60: Leistungsschalter
- 62: Kontaktstift
- 64: kontaktseitigen Abschnitt
- 66: Rastklinke
- 68: Rampenfläche
- 70: Öffnung
- 72: Steg
- 74: Auflage
- 76: Silikonfeder
- 78: Zapfen
- 80: Fenster
- 82: Schrauben
- 84: Querholme
- 86: Längsholme
- 90: Ausrichtelement
- 92: Durchlass
- 94: Steckplatz
- 96: Anschlussstück
- 98: Radien
- 100: verbreiterte Öffnung
- 102: Rampenfläche
- 104: Positionierstifte
- 106: Positionierbohrung
- 107: Formschlussverbindung
- 108: Anlagefläche
- 110: Rastschenkel
- 112: Verriegelungsfläche
- 114: Verbindungsstege

## Patentansprüche

1. Steuervorrichtung (44) für eine elektrische Heizvorrichtung (2) mit einem eine Leiterplatte (40) umgebenden Steuergehäuse (32), das eine mit einem Kühlkörper (46) versehene Trennwand (28) aufweist und zumindest einen mit der Leiterplatte (40) kontaktierten Leistungsschalter (60) aufnimmt, der über einen Niederhalter (52) wärmeleitend gegen den Kühlkörper (46) angelegt ist, **dadurch gekennzeichnet, dass** der Leistungsschalter (60) und der Niederhalter (52) in einer vormontierten Baugruppe (42) verwirklicht sind, die mit dem Kühlkörper (46) verbunden ist.

2. Steuervorrichtung nach Anspruch 1, **dadurch gekennzeichnet, dass** die Baugruppe (42) eine Federeinrichtung (76) aufweist, die zwischen dem Niederhalter (52) und dem Leistungsschalter (60) vorgesehen ist und durch die der Leistungsschalter (60) unter Vorspannung gegen den Kühlkörper (46) angelegt ist.

3. Steuervorrichtung nach Anspruch 2, **dadurch gekennzeichnet, dass** die Federeinrichtung (76) über eine zumindest quer zu der Kraftwirkungsrichtung ihrer Federkraft wirkende Formschlussverbindung an dem Niederhalter (52) gehalten ist.

4. Steuervorrichtung nach Anspruch 2 oder 3, **dadurch gekennzeichnet, dass** die Federeinrichtung durch ein Silikonbauteil (76), insbesondere durch einen Silikonhohlköper gebildet ist.

5. Steuervorrichtung nach einem der Ansprüche 2 bis 4, **dadurch gekennzeichnet, dass** der Leistungsschalter (60) unter Veränderung einer durch die Federeinrichtung (76) bewirkten Vorspannung in der Baugruppe (42) beweglich gehalten ist.

6. Steuervorrichtung nach einem der vorherigen Ansprüche, **dadurch gekennzeichnet, dass** die Baugruppe (42) einen Positionierrahmen (56) aufweist, der zumindest eine Aufnahme (58) für jeweils einen Leistungsschalter (60) ausbildet.

7. Steuervorrichtung nach Anspruch 6, **dadurch gekennzeichnet, dass** der Positionierrahmen (56) und der Niederhalter (52) unter Einschluss des Leistungsschalters (60) und der Federeinrichtung (76) miteinander verclipst sind.

8. Steuervorrichtung nach einem der Ansprüche 6 oder 7, **dadurch gekennzeichnet, dass** der Positionierrahmen (56) eine den Kühlkörper (46) umgebende Öffnung (70) aufweist, die durch eine Auflage (74) für den Leistungsschalter (60) begrenzt ist.

9. Steuervorrichtung nach einem der Ansprüche 6 bis 8, **dadurch gekennzeichnet, dass** der Positionierrahmen (56) ein von zumindest einem Kontaktstift (62) des Leistungsschalters (60) durchragtes Fenster (80) ausbildet, welches oberseitig durch den Niederhalter (52) begrenzt ist.

10. Elektrische Heizvorrichtung (2) mit einem einer Steuervorrichtung (44) nach einem der Ansprüche 1 bis 9, wobei die Trennwand (28) zwischen dem Steuergehäuse (32) und einem Heizergehäuse (3) vorgesehen ist und von der Trennwand (28) zumindest eine PTC-Heizeinrichtung (12) als Heizrippe in das Heizergehäuse (3) hineinragt, wobei die PTC-Heizeinrichtung (12) zumindest ein PTC-Element (14) und zur Bestromung des PTC-Elementes (14) mit unterschiedlicher Polarität mit diesem elektrisch leitend verbundene Kontaktzungen (18), die in dem Steuergehäuse (32) elektrisch angeschlossen sind, aufweist, wobei in der Heizkammer (8) eine Wärmesenke (49) zu dem Kühlkörper (46) freiliegt.

## Claims

1. A control device (44) for an electric heating device (2), having a control housing (32) surrounding a printed circuit board (40), which has a partition wall (28) provided with a cooling body (46) and accommodates at least one power switch (60) contacted with the printed circuit board (40), which is pressed against the cooling body (46) in a thermally conductive manner by means of a hold-down member (52), **characterized in that** the power switch (60) and the hold-down member (52) are embodied in a preassembled assembly (42) which is connected to the cooling body (46).

2. The control device according to claim 1, **characterized in that** the assembly (42) comprises a spring arrangement (76) which is provided between the hold-down member (52) and the power switch (60) and by means of which the power switch (60) is pressed against the cooling body (46) under preload.

3. The control device according to claim 2, **characterized in that** the spring arrangement (76) is held on the hold-down member (52) by means of a positive-fit connection acting at least transversely to the direction of action of its spring force.

4. The control device according to claim 2 or 3, **characterized in that** the spring arrangement is formed by a silicone component (76), in particular by a hollow silicone body.

5. The control device according to one of claims 2 to 4, **characterized in that** the power switch (60) is movably held in the assembly (42) with variation of a preload produced by the spring arrangement (76).

6. The control device according to one of the preceding claims, **characterized in that** the assembly (42) comprises a positioning frame (56) which forms at least one receptacle (58) for a respective power switch (60).

7. The control device according to claim 6, **characterized in that** the positioning frame (56) and the hold-down member (52) are clipped together with the power switch (60) and the spring arrangement (76) enclosed therebetween.

8. The control device according to one of claims 6 or 7, **characterized in that** the positioning frame (56) has an opening (70) surrounding the cooling body (46), which is delimited by a support surface (74) for the power switch (60).

9. The control device according to one of claims 6 to 8, **characterized in that** the positioning frame (56) forms a window (80) through which at least one contact pin (62) of the power switch (60) extends, which window is delimited on its upper side by the hold-down member (52).

10. An electric heating device (2) with a a control device (44) according to one of claims 1 to 9, wherein the partition wall (28) is provided between the control housing (32) and a heater housing (3), and at least one PTC heating device (12) projects from the partition wall (28) into the heater housing (3) as a heating fin, wherein the PTC heating device (12) comprises at least one PTC element (14) and contact tabs (18) electrically conductively connected thereto with different polarity for supplying electric current to the PTC element (14), which contact tabs are electrically connected in the control housing (32), wherein a heat sink (49) is exposed towards the cooling body (46) in the heating chamber (8).

## Revendications

1. Dispositif de commande (44) pour un dispositif de chauffage électrique (2), comportant un boîtier de commande (32) entourant une carte de circuit imprimé (40), qui présente une cloison de séparation (28) munie d'un corps de refroidissement (46) et reçoit au moins un interrupteur de puissance (60) mis en contact avec la carte de circuit imprimé (40), lequel est appliqué contre le corps de refroidissement (46) de manière thermoconductrice au moyen d'un organe de maintien (52), **caractérisé en ce que** l'interrupteur de puissance (60) et l'organe de maintien (52) sont réalisés dans un ensemble prémonté (42) qui est relié au corps de refroidissement (46).

2. Dispositif de commande selon la revendication 1, **caractérisé en ce que** l'ensemble (42) comprend un dispositif élastique (76) qui est prévu entre l'organe de maintien (52) et l'interrupteur de puissance (60) et au moyen duquel l'interrupteur de puissance (60) est appliqué sous précontrainte contre le corps de refroidissement (46).

3. Dispositif de commande selon la revendication 2, **caractérisé en ce que** le dispositif élastique (76) est maintenu sur l'organe de maintien (52) au moyen d'une liaison par complémentarité de formes agissant au moins transversalement à la direction d'action de sa force de ressort.

4. Dispositif de commande selon la revendication 2 ou 3, **caractérisé en ce que** le dispositif élastique est formé par un composant en silicone (76), en particulier par un corps creux en silicone.

5. Dispositif de commande selon l'une des revendications 2 à 4, **caractérisé en ce que** l'interrupteur de puissance (60) est maintenu de manière mobile dans l'ensemble (42) avec modification d'une précontrainte produite par le dispositif élastique (76).

6. Dispositif de commande selon l'une des revendications précédentes, **caractérisé en ce que** l'ensemble (42) comprend un cadre de positionnement (56) qui forme au moins un logement (58) destiné chacun à un interrupteur de puissance (60).

7. Dispositif de commande selon la revendication 6, **caractérisé en ce que** le cadre de positionnement (56) et l'organe de maintien (52) sont encliquetés l'un avec l'autre en enfermant l'interrupteur de puissance (60) et le dispositif élastique (76).

8. Dispositif de commande selon l'une des revendications 6 ou 7, **caractérisé en ce que** le cadre de positionnement (56) présente une ouverture (70) entourant le corps de refroidissement (46), laquelle est délimitée par une surface d'appui (74) pour l'interrupteur de puissance (60).

9. Dispositif de commande selon l'une des revendications 6 à 8, **caractérisé en ce que** le cadre de positionnement (56) forme une fenêtre (80) traversée par au moins une broche de contact (62) de l'interrupteur de puissance (60), laquelle est délimitée sur son côté supérieur par l'organe de maintien (52).

10. Dispositif de chauffage électrique (2) avec un un dispositif de commande (44) selon l'une des revendications 1 à 9, dans lequel la cloison de séparation (28) est prévue entre le boîtier de commande (32) et un boîtier de chauffage (3), et au moins un dispositif de chauffage PTC (12) fait saillie depuis la cloison de séparation (28) dans le boîtier de chauffage (3) sous la forme d'une ailette chauffante, dans lequel le dispositif de chauffage PTC (12) comprend au moins un élément PTC (14) et des languettes de contact (18) reliées à celui-ci de manière électriquement conductrice avec une polarité différente pour l'alimentation en courant de l'élément PTC (14), lesquelles sont raccordées électriquement dans le boîtier de commande (32), dans lequel un dissipateur thermique (49) est exposé vers le corps de refroidissement (46) dans la chambre de chauffage (8).
